Europäisches Patentamt

European Patent Office

Office européen des brevets

(11) Publication number: **0 107 480**
**A2**

# EUROPEAN PATENT APPLICATION

(21) Application number: **83306361.3**

(22) Date of filing: **19.10.83**

(51) Int. Cl.³: **H 01 L 33/00**

(30) Priority: **21.10.82 JP 185871/82**

(43) Date of publication of application: **02.05.84**
Bulletin 84/18

(84) Designated Contracting States: **DE FR GB IT**

(71) Applicant: **IDEC IZUMI CORPORATION,**
**10-40 Mikunihonmachi-1-chome, Yodogawa-ku Osaka**
**(JP)**

(72) Inventor: **Fujita, Teizo, 118-135,**
**Kitakasugaoka-1-chome, Ibaraki-shi (JP)**
Inventor: **Kimura, Haruo, 44-5, Tsuneo-2-chome,**
**Takatsuki-shi (JP)**

(74) Representative: **Miller, Joseph et al, J. MILLER & CO.**
**Lincoln House 296-302 High Holborn, London WC1V 7JH**
**(GB)**

(54) Light emission diode lamp and method of producing it.

(57) Disclosed is a light emission diode lamp comprising a light emission diode lamp unit (1) in which a lead-conductor (4) and a plurality of light emission diode elements (5) connected to the lead-conductor are integrally embedded in a molding (7) of light transmissive resin, a lamp cap (3, 9), a substantially hollow-cylindrical spacer (2) inserted between the light emission diode lamp unit (1) and the lamp cap (3, 9), and a current limiting element (8) connected between the lead-conductor (4) and a contact (33) formed at the lower end portion of the lamp cap (3, 9).

Further disclosed is a method for producing a light emission diode lamp comprinsing the steps producing a lead-conductor (4) having lead-substrate portions (4A) and pecti-natedly formed lead-strip portions (4b) predeterminedly connected to the lead-substrate portions (4a), connecting light emission diode elements (5) to the lead-substrate portions (4a) and connecting the light emission diode elements (5) to each other through lead wires (6), integrally embedding the light emission diode elements (5), the lead-conductor (4) and the lead wires (6) in a light transmissive resin molding (7) with the ends of the lead-strip portions (4b) exposed outside, so as to form a light emission diode lamp unit (1), cutting off unnecessary portions of the exposed ends of the lead-strip portions (4b), connecting a current limiting element (8) at its one end to a given one of the lead-strip portions (4b), attaching a substantially hollow-cylindrical spacer (2) to the light emission diode lamp unit (1), attaching a lamp cap (3, 9) to the spacer (2), connecting the current limiting element (8) at its other end to a contact (33) formed at the lower end portion of the lamp cap (3, 9), and connecting another one of the lead-strip portions (4b) to a side portion of the lamp cap (3, 9) electrically insulated from the contact (33).

ACTORUM AG

- 1 -

LIGHT EMISSION DIODE LAMP

AND METHOD OF PRODUCING IT

The present invention relates to a lamp using a light emission diode (hereinafter referred to as a light emission diode lamp) and a method of producing it.

When comparison is made between a light emission diode lamp and a small-sized incandescent lamp as an illumination source, it is known well that the former is superior to the latter in life, reliability, consumed power, etc. Recently, such an advantageous light emission diode lamp is being developed. However, there is a problem in the interchangeability between such a light emission diode lamp and the conventional incandescent lamp in practical use. As an solution of this problem, a so-called lamp-cap type light emission diode lamp, which comprises a light emission diode as an illumination source and a lamp cap similar to that of an incandescent lamp as a terminal member to be connected to a power source, has been used.

An object of the present invention is to provide a light emission diode lamp and a method for producing thereof in which the connection between a lead-conductor of a light emission diode and a lamp cap can be easily performed so as to be preferable for the mass production of such a light emission diode lamp.

Another object of the present invention is to provide a light emission diode lamp and a method for

0107480

producing thereof in which the light emission diode lamp has a stable characteristic such that disconnection and/or ricketiness is prevented from occurring even when an external force such as vibrations, shocks, rotational force, or the like, is applied to the light emission diode lamp.

The above and other objects, features and advantages of the present invention will be apparent from the following detailed description of preferred embodiments thereof taken in conjunction with the accompanying drawings, in which:

Fig. 1 is a perspective view of an embodiment of the light emission diode lamp according to the present invention;

Fig. 2 is an exploded perspective view of the embodiment of Fig. 1;

Fig. 3 is a plan view of the embodiment of Fig. 1;

Fig. 4 is a longitudinal front view partly in section along IV-IV line in Fig. 3;

Fig. 5 is a longitudinal side view partly in section along V-V line in Fig. 4;

Fig. 6 is a perspective view of the conductor for explaining the process of producing the light emission diode lamp according to the present invention;

Fig. 7 is a front view of the lead-conductor shown in Fig. 6;

Fig. 8 is a circuit diagram of a light emission diode lamp in which light emission diodes are connected in series with each other;

Fig. 9 is a plan view of the lead-substrate portion showing an actually wired state of the circuit as shown in Fig. 8;

Fig. 10 is a circuit diagram of a light emission diode lamp in which light emission diodes are connected in series-parallel with each other;

Fig. 11 is a plan view of the lead-substrate portion showing an actually wired state of the circuit as shown in Fig. 10;

Fig. 12 is a perspective view of another embodiment of the light emission diode lamp according to the present invention;

Fig. 13 is a plan view of the embodiment of Fig. 12;

Fig. 14 is a longitudinal front view partly in section along XIV-XIV line in Fig. 13; and

Fig. 15 is a longitudinal side view partly in section along XV-XV line in Fig. 14.

Referring to the drawings, preferred embodiments of the present invention will be described hereunder.

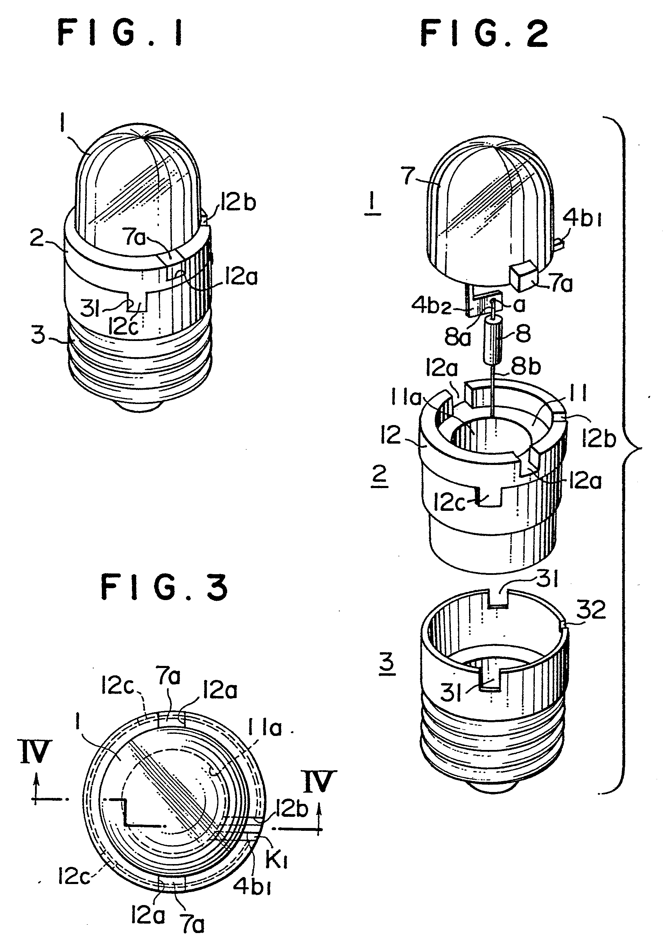

Figs. 1 to 11 show an embodiment of the present invention. In producing the light emission diode lamp according to the present invention, a light emission diode lamp unit 1, a spacer 2 and an Edison type lamp cap 3 are preliminarily individually produced. The lamp unit 1 is produced such that light emission diode elements 5 are attached onto corresponding lead-substrates 4a of a lead-conductor 4 and connected with each other by lead wires 6, and then the light emission diode elements 5, the lead-conductor 4 and the lead wires 6 are integrally embedded in a molding of a light transmissible resin material 7 with only the respective ends of lead-strip portions 4b exposed outside.

Reference numeral 8 designates a current limiting element which is a resistor or a capacitor suitable for the working voltage and current to enable the light emission diode elements 5 to be actuated to illuminate through this current limiting element 8.

According to the present invention, protrusions 7a and 7a are integrally formed in the light transmissible molding 7 at its lower end portion such that the protrusions 7a and 7a can respectively engage with axially formed grooves 12a and 12a of the spacer 2 which will be described later more in detail.

The lead-conductor 4 is bent at a right angle at its upper end portion to form the above-mentioned lead-substrate portions 4a extending in the radial direction of the above-mentioned spacer 2. The above-mentioned lead-strip portions 4b extending in the axial direction of the spacer 2 are formed at the lower portion of the lead-conductor 4 and previously connected to each other through connecting portions 4c of the lead-conductor 4.

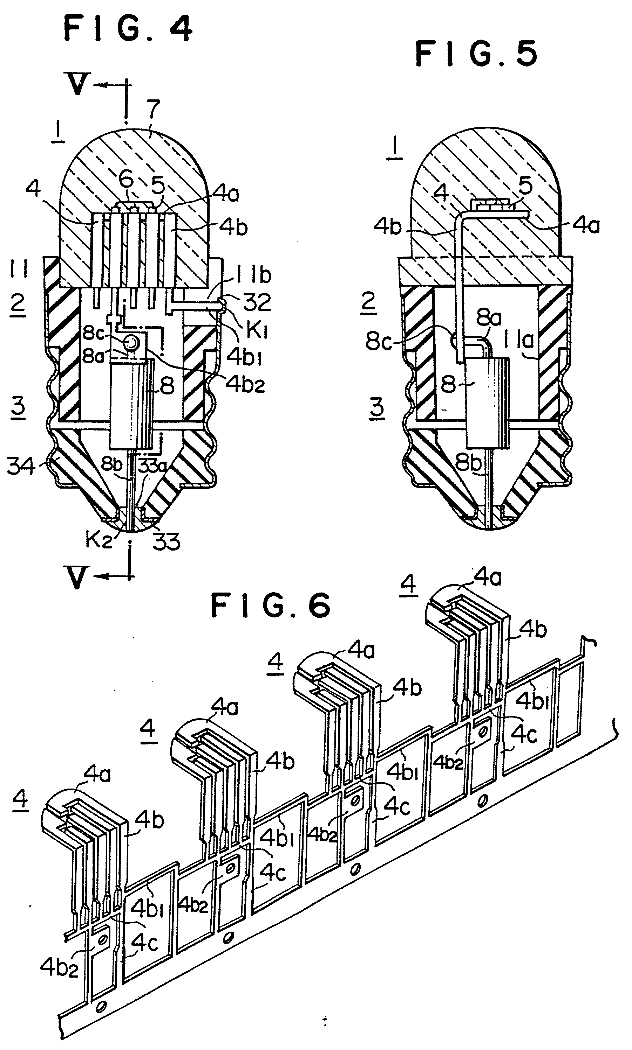

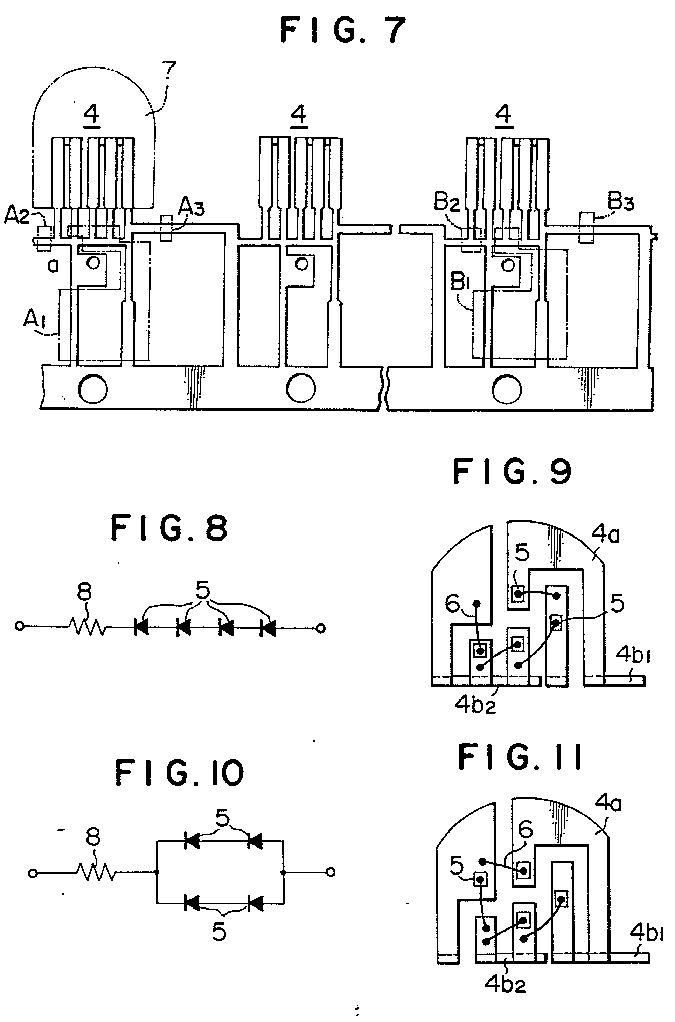

Referring to Figs. 6 and 7, a series of continued unit blocks each for the lead-conductor 4 is punched out of a conductive sheet by using a press. The respective unit blocks are connected through the connecting portions 4c and each of the unit blocks includes five digitally divided lead-strip portions 4b and the lead-substrate portions 4a which are previously shaped so that the light emission diode elements 5 may be properly attached thereto. In this embodiment, two of the lead-strip portions 4b of each block are formed as a pair of connecting terminals $4b_1$ and $4b_2$. More particularly, a part of one of the connecting portions 4c is used to form the connecting terminal $4b_1$ which is to be connected to the Edison type lamp cap 3, while one of the lead-strip portions $4b_2$ is downward extended and the extended end portion is rectangularly shaped to form the connecting terminal 4b to which the resistor 8 is to be connected.

As to each unit block, namely each lead-conductor 4, the light emission diode elements 5 are attached onto the lead-substrate portions 4a and the attached light emission diode elements 5 are previously connected. Then each unit block or lead-conductor 4 including the lead-substrate portions 4a, the light emission diode elements 5 and the lead-strip portions 4b are embedded in the light transmissive resin molding 7 with the respective ends of the lead-strip portions 4b exposed outside the molding 7. Thereafter, the respective unit blocks are separated into individual lead-conductors 4 by properly cutting off unnecessary parts of the connecting portions 4c. In Fig. 7 the portions $A_1$, $A_2$, $A_3$, $B_1$, $B_2$, $B_3$ indicated by two-dotted line are the unnecessary parts of the connecting portions 4c to be selectively cut off. That is, for example, in the case where four light emission diode elements 5 are used to constitute such a series-connected circuit as shown in Fig. 8, the connecting portions 4c are cut off at the parts $A_1$, $A_2$ and $A_3$ and connections are previously made at the lead-substrate portions 4a. On the other hand, in the case where each pair of the light emission diode elements 5 are connected in series to each other and the thus series-connected two pairs are connected in parallel with each other as shown in Fig. 10, the connecting portions 4c are cut off at the parts $B_1$, $B_2$ and $B_3$ and necessary connection is made predeterminedly at the lead-substrate portions 4a as shown in Fig. 11.

Although in the embodiment, each unit block is arranged to have five lead-strip portions 4b, it is of course that the present invention is not limited to this number of the lead-strip portions 4b and at least two lead-strip portions may be sufficient to constitute each unit block and that the number of the light emission diode elements to be attached to the lead-substrate may be selected in accordance with the demand.

The spacer 2 of an insulator material has a substantially cylindrical external form, and a support portion 11 on which the lamp unit 1 may be mounted is formed at the upper opening portion of the spacer 2. A through hole 11a is formed at the center of the support portion 11 so that the respective forward ends of the lead-strip portions 4b and the connecting terminals $4b_1$,

$4b_2$ extending downward from the lower end of the lamp unit 1 and the resistor 8 can be passed therethrough. A circumferential wall 12 is uprightly formed around the support portion 11 and longitudinal grooves or slots 12a, 12a and 12b are formed at three portions of the circumferential wall 12. Two of these three longitudinal grooves or slots 12a and 12a are formed in opposition to each other so that the pair of protrusions 7a and 7a can perform uneven engagement with these pair of grooves or slots 12a and 12a. A guide groove or slot 11b continued to the longitudinal groove or slot 12b is formed in the circumferential wall 12 at a portion under the opening plane of the support portion 11 so that the connecting terminal $4b_1$ may be led into this guide groove or slot 11b when the lamp unit 1 is attached to the spacer 2. Further, in the spacer 2, a pair of protrusions 12c and 12c downward extending from the lower end of the circumferential wall 12 are formed in opposition to each other, so that uneven engagement can be made between these protrusions 12c and 12c and grooves or slots 31 and 31 formed at the upper opening portion of the lamp cap 3. As the lamp cap 3, a one available on the market is usually used after it has been somewhat worked. In this embodiment, an Edison type lamp cap is used and three grooves or slots 31, 31 and 32 are formed in the lamp cap at its upper opening end portion. The two grooves or slots 31 and 31 is formed in opposition to each other so that they are used for the uneven engagement with the protrusions 12c and 12c of the spacer 2 as described above. The other groove or slot 32 is formed corresponding to the led-out portion of the connecting terminal $4b_1$. Reference numeral 33 designates a contact formed at a lower end portion of the lamp cap 3 and insulated from the lamp cap 3 with an insulating material 34.

In assembling the thus prepared components to constitute a light emission diode lamp, an upper lead wire 8a of the current limiting element 8 is inserted into and passed through a through hole $\underline{a}$ formed in the connecting terminal $4b_2$ extending downward from the lower end of the lamp unit 1 and soldered thereat. The lamp unit 1 with the current limiting element 8 soldered thereto is put on the spacer 2 at its upper opening side so that the protrusions 7a and 7a engage with the respective longitudinal grooves or slots 12a and 12a to fixedly attach the lamp unit 1 to the spacer 2. In the present state, the lower lead wire 8b of the current limiting element 8 is exposed at the lower side of the spacer 2. Next, the protrusions 12a and 12a of the spacer 2 are engaged with the grooves or slots 31 and 31 of the lamp cap 3 to attach the lamp cap 3 to the assembly of the lamp unit 1 and the spacer 2 such that the lead wire 8b of the current limiting element 8 is passed through a through hole 33a formed in the contact 33 at its center. At this time, the connecting terminal $4b_1$ is led in the groove or slot 32 of the lamp cap 3. Finally, soldering is applied to the gap Kl between the connecting terminal $4b_1$

and the lamp cap 3 and the gap K2 between the lead wire 8b and the contact 33 to thereby ensure the electrical and mechanical connection therebetween to complete the assembling of the light emission diode lamp.

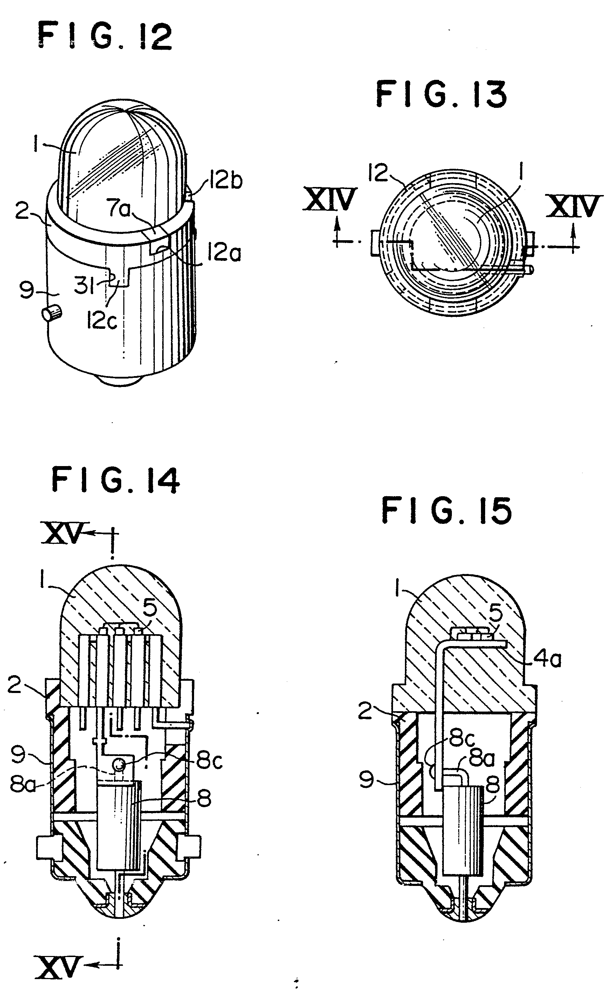

Figs. 12 to 15 illustrate another embodiment of the light emission diode lamp according to the present invention. This embodiment is substantially the same as the first embodiment excepting that a swan type lamp cap 9 is used in this embodiment. In Figs. 12 to 15, the same component as that used in the first embodiment is represented by the same reference numeral or symbol and the description about the procedure of assembling is omitted here because it is quite the same as in the first embodiment.

The lamp cap is not always limited to such an Edison type or such a swan type, according to the present invention, but any type lamp cap, such as for an aircraft, available on the market can of course be used.

In addition, the standardized dimension of the upper opening portion of the swan type lamp cap 9 is normally different from that of the Edison type lamp cap 3. However, the inside diameter of the upper opening portions of the spacer 2 engaged with the swan type lamp cap 9 and that of the spacer 2 engaged with the Edison type lamp cap 3 can be worked as the same dimension and the outside diameters of the lower opening portions of these spacers 2 are worked as the different dimensions in order to engage with the swan type and the Edison type lamp caps 3, 9 respectively.

As described above, according to the present invention, assembling is performed such that the lamp unit 1 is attached to the lamp cap 3 or 9 through the spacer 2 after the lamp unit 1 has been first attached to the spacer 2 so that the pair of lead-strip portions led out from the lead-substrate, the lamp cap, and the contact formed at the bottom portion of the lamp cap can be put in place in the processes successively assembling the components, resulting in facilitation of electrical connection. Thus, the present invention is advantageous in that the mass production of light emission diode lamps of this type is enabled so as to improve the efficiency in production to provide inexpensive light emission diode lamps. Further, the lamp unit 1, the spacer 2 and the lamp cap 3 or 9 are arranged such that they are readily attached with each other through uneven engagement so that a light emission diode lamp having such a stable performance that there is little possibility of occurrence of disconnection at the soldered portions or ricketiness between the lamp unit 1 and the lamp cap 3 or 9 even in the case an external force such as vibrations, shocks, rotational forces, etc. is applied to the lamp.

CLAIMS

1.      A light emission diode lamp comprising:

a light emission diode lamp unit (1) in which a lead-conductor (4) and a plurality of light emission diode elements (5) connected to said lead-conductor are integrally embedded in a molding (7) of light transmissive resin;

a lamp cap (3, 9);

a substantially hollow-cylindrical spacer (2) inserted between said light emission diode lamp unit (1) and said lamp cap (3, 9); and

a current limiting element (8) connected between said lead-conductor (4) and a contact (33) formed at the lower end portion of said lamp cap (3, 9), said contact being electrically insulated from said lamp cap.

2.      A light emission diode lamp according to claim 1, in which each of said light emission diode lamp unit (1), said spacer (2) and said lamp cap (3, 9) is provided with uneven engagement means (7a, 12a, 12b, 12c, 31, 32) through which said light emission diode lamp unit (1), said spacer (2) and said lamp cap (3, 9) are integrally assembled.

3.      A light emission diode lamp according to claim 1, in which said lamp cap (3, 9) is of the Edison type.

4.      A light emission diode lamp according to claim 1, in which said lamp cap (3, 9) is of the swan type.

5.      A light emission diode lamp according to claim 2, in which said lamp cap (3, 9) is of the Edison type.

0107480

6.    A light emission diode lamp according to claim 2, in which said lamp cap (3, 9) is of the swan type.

7.    A light emission diode lamp according to claim 1, in which said current limiting element (8) is a resistor.

8.    A light emission diode lamp according to claim 1, in which said current limiting element (8) is a capacitor.

9.    A method for producing a light emission diode lamp comprising the steps of:

producing a lead-conductor (4) having a plurality of lead-substrate portions (4A) and a plurality of pectinatedly formed lead-strip portions (4b) predeterminedly connected to said lead-substrate portions (4a);

connecting a plurality of light emission diode lamp elements (5) to said lead-substrate portions (4a) and connecting said light emission diode elements (5) to each other through lead wires (6);

integrally embedding said plurality of light emission diode elements (5), said lead-conductor (4) and said lead wires (6) in a molding (7) of a light transmissive resin material with the respective ends of said lead-strip portions (4b) exposed outside, so as to form a light emission diode lamp unit (1);

cutting off unnecessary portions of said respective exposed ends of said lead-strip portions (4b);

connecting a current limiting element (8) at its one end to a given one of said plurality of lead-strip portions (4b);

attaching a substantially hollow-cylindrical spacer (2) at its one opening end to said light emission diode lamp unit (1);

attaching a lamp cap (3, 9) to said spacer (2) at the other opening end thereof;

connecting said current limiting element (8) at its other end to a contact (33) formed at the lower end portion of said lamp cap (3, 9); and

connecting another one of said plurality of lead-strip portions (4b) to a side surface portion of said lamp cap (3, 9) electrically insulated from said contact (33).

10. A method for producing a light emission diode lamp according to claim 9, in which in said unnecessary portion cutting off step, said unnecessary portion of said plurality of lead-strip portions (4b) are cut off such that said light emission diode elements (5) can be connected in series with each other.

11. A method for producing a light emission diode lamp according to claim 9, in which in said unnecessary portion cutting off step, said unnecessary portion of said plurality of lead-strip portions (4b) are cut off such that said light emission diode elements (5) can be connected in series-parallel with each other.

12. A method for producing a light emission diode lamp according to claim 9, in which said current limiting element (8) is a resistor.

13. A method for producing a light emission diode lamp according to claim 9, in which said current limiting element (8) is a capacitor.

0107480

F I G . 1

F I G . 2

F I G . 3

FIG. 4

FIG. 5

FIG. 6

# FIG. 7

# FIG. 8

# FIG. 9

# FIG. 10

# FIG. 11

# F I G. 12

# F I G. 13

# F I G. 14

# F I G. 15